# EUROPEAN PATENT APPLICATION

(11) **EP 2 587 491 A1**
(43) Date of publication of application: **01.05.2013**
(21) Application number: 11797916.1
(22) Date of filing: 25.04.2011
(51) Int. Cl.: H01B 5/14, C23C 14/34, H01B 13/00, H01L 31/04, H01M 4/131, H01M 4/485, H01M 10/0525, H01M 10/0562, H01M 14/00

(54) **TRANSPARENT CONDUCTIVE FILM, METHOD FOR MANUFACTURING A TRANSPARENT CONDUCTIVE FILM, DYE-SENSITIZED SOLAR CELL, AND SOLID-ELECTROLYTE CELL**

(30) Priority: 23.06.2010 JP 2010142549
(71) Applicant: Sony Corporation, Tokyo 108-0075 (JP)
(72) Inventor: FURUYA, Tatsuya, Tokyo 108-0075 (JP)
(74) Representative: Müller - Hoffmann & Partner
(86) International application number: PCT/JP2011/060569
(87) International publication number: WO 2011/162028

(57) **Abstract**

To provide a novel transparent conductive film using low-cost materials that can be stably supplied and have low toxicity, a method of manufacturing the same, a dye-sensitized solar cell, and a solid electrolyte battery.

The transparent conductive film is formed by a sputtering method in a nitrogen-containing atmosphere using Li₄Ti₅O₁₂ as a target. The transparent conductive film is a novel transparent conductive film, which contains Li, Ti, O, and N and has the TiN type crystal structure.

## Description

### TECHNICAL FIELD

The present invention relates to a transparent conductive film and a method of manufacturing the same, a dye-sensitized solar cell, and a solid electrolyte battery.

### BACKGROUND ART

The transparent conductive film is transparent and electrically conductive and is used as transparent electrodes for display panels and solar cells, etc.

The transparent conductive films which have been mainly used heretofore are indium tin oxide (ITO) films of which tin oxide is added to indium oxide, Sb-doped tin oxide (ATO) films of which tin oxide is doped with antimony, and F-doped tin oxide (FTO) films of which tin oxide is doped with fluorine, etc.

The ITO film has excellent properties for the transparent conductive film such as low resistivity, high transparency, and good electrochemical stability, but is high cost because of inclusion of rare metal indium (In) and very hazardous to human. As ITO and FTO films are used as the transparent electrode of solar cells, they have problems of diffusing tin in the transparent electrode into the photoelectric conversion layer leading to deterioration of the performance of the device.

Patent Document 1 describes an anticorrosive transparent conductive film of which a protective film including titanium nitride or oxygen-containing titanium nitride is formed on the surface of the transparent conductive film including indium oxide or tin oxide as a main component.

### CITATION LIST

### PATENT DOCUMENT

Patent Document 1: Japanese Patent Application Laid-Open No. S63-102108

### SUMMARY OF THE INVENTION

### PROBLEMS TO BE SOLVED BY THE INVENTION

Since indium, a constituent element of ITO films, is a rare metal and has concerns of resource depletion, alternative materials have been sought. As new transparent conductive films inexpensive deposition processes, use of cheap materials, and the environmentally friendly and non-toxic materials have also been required.

Therefore, the purpose of the present invention is to provide a novel transparent conductive film using materials with low cost, stable supply, and low toxicity and a method of manufacturing the same, a dye-sensitized solar cell, and a solid electrolyte battery using the transparent conductive film.

### SOLUTIONS TO PROBLEMS

To solve the problems above, the first invention is to provide a transparent conductive film formed by a physical vapor deposition method in a nitrogen- containing atmosphere using Li₄Ti₅O₁₂ as a target.

The second invention is to provide a method of manufacturing the transparent conductive film, including forming the transparent conductive film by the physical vapor deposition method in the nitrogen-containing atmosphere using Li₄Ti₅O₁₂ as the target.

The third invention is to provide a dye-sensitized solar cell including a transparent conductive layer, a photoelectrode layer, an electrolyte layer, and a counter electrode, wherein the transparent conductive layer contains the transparent conductive film formed by the physical vapor deposition method in the nitrogen-containing atmosphere using Li₄Ti₅O₁₂ as the target.

The fourth invention is to provide a solid electrolyte battery including a cathode layer, an anode layer, and a solid electrolyte layer, wherein the anode layer contains the transparent conductive film formed by the physical vapor deposition method in the nitrogen-containing atmosphere using Li₄Ti₅O₁₂ as the target.

### EFFECTS OF THE INVENTION

The present invention can provide the novel transparent conductive film using the materials with low cost, stable supply, and low toxicity and the method of manufacturing the same, the dye-sensitized solar cell, and the solid electrolyte battery.

### BRIEF DESCRIPTION OF DRAWINGS

Fig. 1 is a section diagram for illustrating a constitutional example of the dye-sensitized solar cell according to the embodiment of the invention.
Fig. 2 is a section diagram for illustrating a constitutional example of the solid electrolyte battery according to the embodiment of the invention.
Fig. 3 is a picture of the transparent conductive film in Example 1.
Fig. 4 is a picture to demonstrate the results of evaluating with a tester the performance of the transparent film in Comparative Example 1.
Fig. 5 is an X-ray photoelectron spectroscopy (XPS) spectrum of the transparent conductive film in Example 1.
Fig. 6 is an X-ray diffraction (XRD) pattern of the transparent conductive film in Example 1.

### MODE FOR CARRYING OUT THE INVENTION

The embodiment of the invention will be now described below with reference to the drawings. Description will be carried out in the following order.
1. First embodiment (Example of the transparent conductive film)
2. Second embodiment (Example of the dye-sensitized fuel cell using the transparent conductive film)
3. Third embodiment (Example of the thin film battery using the transparent conductive film)
4. Other embodiment (Modified example)

### (Transparent Conductive Film)

The transparent conductive film according to the first embodiment of the invention will be described. The transparent conductive film is the film formed by the sputtering technique in the physical vapor deposition method in the nitrogen-containing atmosphere using Li₄Ti₅O₁₂ as the target. The transparent conductive film contains Li, Ti, 0, and N and is a novel transparent conductive film with good transparency. The transparent conductive film is the novel transparent conductive film with the TiN-type crystal structure, which has been confirmed by the X-ray diffraction (XRD) analysis.

### (Method of Manufacturing Transparent Conductive Film)

A sintered compact of Li₄Ti₅O₁₂ can be used as the target. The sintered compact of Li₄Ti₅O₁₂ can be obtained, for example, by molding and sintering of Li₄Ti₅O₁₂ powder synthesized by the solid phase reaction in which Li₂CO₃ power and TiO₂ powder are applied as the raw materials.

The transparent conductive film can be manufactured by the radio frequency (RF) magnetron sputtering method in the nitrogen-containing atmosphere using the sintered compact of Li₄Ti₅O₁₂ as the target. In this case the deposition temperature can be set at ambient temperature. A type of the sputtering method is not limited to the RF magnetron sputtering method, but other sputtering methods such as RF sputtering method can be used.

For example, the transparent conductive film can be manufactured by deposition using the RF magnetron sputtering equipment under the conditions of the gas pressure at 0.5 Pa, the power output at 50 W, the Ar flow rate of 10 sccm and the N₂ flow rate of 10 sccm, and the deposition temperature at ambient temperature. The electric resistivity of the transparent conductive film measured by the four probe method was 2.56 MΩ/sq.

Since the transparent conductive film in the first embodiment of the invention does not use indium, it is cheap and non-hazardous. Since deposition at ambient temperature is possible, choice of substrate materials becomes wider.

### 2. Second Embodiment

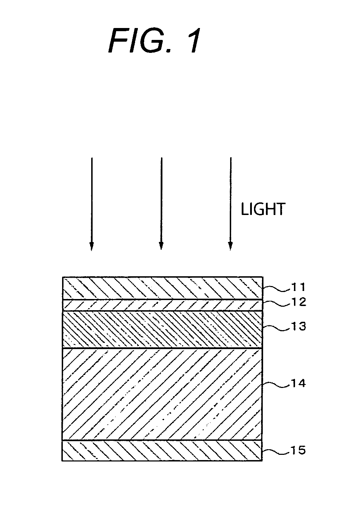

The dye-sensitized solar cell using the transparent conductive film described above will be described. Fig. 1 illustrates arrangement of the dye-sensitized solar cell according to the second embodiment of the invention. The dye-sensitized solar cell includes the transparent substrate 11, the transparent conductive layer 12, the photoelectrode layer 13, the electrolyte 14, and the counter electrode 15. The dye-sensitized solar cell has arrangement in which the transparent conductive layer 12 is formed on the transparent substrate 11 and the photoelectrode layer 13, the electrolyte 14, and the counter electrode 15 are arranged in this order on the transparent conductive layer 12.

### (Transparent Substrate 11)

Glass substrates, flexible substrates such as films, etc. can be used as the transparent substrate 11. The transparent substrates 11 are not limited to the illustrated examples, but various types of the substrates can be used so far as they are transparent.

### (Transparent Conductive Layer 12)

The transparent conductive film according to the first embodiment can be used as the transparent conductive layer 12. That is, as the transparent conductive layer 12 the film formed by the sputtering deposition technique in the nitrogen-containing atmosphere using Li₄Ti₅O₁₂ as the target can be used.

The transparent conductive layer 12 may have arrangement of two or three layers or more. In this case, since the transparent conductive film according to the first embodiment is composed of the materials resistant to the corrosion by electrolyte solution, it is preferably arranged on the layer which contacts the electrolyte 14. As the materials for composition of other layers of the transparent conductive film, those known in the prior art can be used. Specifically, they include ITO, FTO, ATO, SnO₂, ZnO, composite indium-zinc oxide (IZO), etc. The transparent conductive film composed of other layers can be formed by the prior art techniques such as the vapor deposition method, the sputtering method, and the coating method.

### (Photoelectrode Layer 13)

The photoelectrode layer 13 is formed on the transparent conductive layer 12 by deposition and sintering of semiconductor particles such as TiO₂. and is a dye-supported porous film. The semiconductor particles are selected such that an average particle size of primary particles is ranging, for example, from 1 nm to 200 nm, more preferably from 5 nm to 100 nm. The photoelectrode layer 13 is preferably the n-type semiconductor, in which upon photoexcitation electrons in the conduction band become carriers to provide the anodic current.

The semiconductor includes, in addition to TiO₂, metal oxide semiconductors such as MgO, ZnO, WO₃, Nb₂O₅, TiSrO₃, or SnO₂. Among them TiO₂ (anatase-type structure) is preferred. The type of semiconductors is not limited to the illustrated examples, but various materials can be used. Two or more types of these semiconductors can also be used as a mixture. A mixture of semiconductor particles with different average particle sizes can also be used as the material for the photoelectrode layer 13.

### (Dye)

The photoelectrode layer 13 has a supported dye with the sensitizing effects. The dye includes ruthenium complex dyes, metal complex dyes such as complexes of platinum, zinc, and palladium, and organic dyes such as methine dyes, xanthene dyes, porphyrin dyes, azo dyes, coumarin dyes, and polyene dyes. Two or more types of these dyes can be used as a mixture.

### (Counter Electrode 15)

Platinum, carbon electrodes, conductive polymers, etc. can be used as the counter electrode 15.

### (Electrolyte 14)

The electrolyte 14 is, for example, the system of which the material capable of generating at least one type of the reversible oxidation/reduction state (redox system) is dissolved in the electrolyte 14. Examples of the redox system include halogens such as I⁻/I₃⁻ and Br⁻/Br₂, pseudohalogens such as quinone/hydroquinone and SCN-/(SCN)₂, Fe (II) ion/Fe (III) ion, and Cu (I) ion/Cu (II) ion, but are not limited to these examples.

The electrolyte 14 can be liquid electrolytes, polymer electrolytes of which the liquid electrolytes are incorporated into polymer materials (gel electrolyte), solid polymer electrolytes or solid inorganic electrolytes. Specifically, it includes a combination of iodine (I₂) with metal iodides or organic iodides, a combination of bromine (Br₂) with metal bromides or organic bromides, sulfur compounds such as ferrocyanides/ferricyanides or ferrocene/ferricyanium ion, viologen dyes, and hydroquinone/quinone. The cations for the metal compounds are preferably Li, Na, K, Mg, Ca, Cs, etc., and those for the organic compounds are preferably the quaternary ammonium ions such as the tetraalkylammonium ions, pyridinium ions, and imidazolium ions, but are not limited to these examples and two or more types of these cations can be used as a mixture. Among them the electrolytes of which I₂ is combined with ionic liquids such as LiI, NaI, imidazolium iodide, and quaternary ammonium iodides are preferred. To improve the open circuit voltage various additives such as 4-tert-butylpyridine or a carboxylic acid can be added.

The solvents include, for example, nitriles such as acetonitrile, carbonates such as propylene carbonate or ethylene carbonate, γ-butyrolactone, pyridine, dimethylacetamide or other polar solvents, ambient temperature molten salts such as methylpropylimidazolium iodides, or mixtures thereof. More commonly the solvents can be water, alcohols, ethers, esters, carbonic esters, lactones, carboxylate esters, phosphate triesters, heterocyclic compounds, nitriles, ketones, amides, nitromethane, halogenated hydrocarbons, dimethylsulfoxide, sulfolane, N-methylpyrrolidone, 1,3-dimethylimidazolidinone, 3-methyloxazodinone, hydrocarbons, etc. and two or more types of these solvents can be used as a mixture. The solvents can also be the ionic liquids of quaternary ammonium salts such as tetraalkylammonium-, pyridinium- or imidazolium-type salts.

If necessary, supporting electrolytes can be added to the electrolyte 14. The supporting electrolytes include inorganic salts such as lithium iodide and sodium iodide, and molten salts such as imidazolium salts and quaternary ammonium salts.

The dye-sensitized solar cell works as the battery as follows. That is, the incoming light from the side of the transparent substrate 11 passes through the transparent substrate 11 and the transparent conductive layer 12 to hit the dye, which is raised to the excited state to release electrons. The electrons diffuse through the semiconductor particles reaching the transparent conductive layer 12 and moving outwards. The dye from which electrons are released receives electrons from ions in the electrolyte 14. The ions from which electrons are released receive electrons once again from the surface of the counter electrode 15 to return to the state before releasing electrons.

### (Method of Manufacturing Dye-sensitized Solar Cell)

The transparent conductive layer 12 is formed on the transparent substrate 11. The transparent conductive layer 12 is formed by the sputtering deposition technique in the nitrogen-containing atmosphere using the sintered compact of Li₄Ti₅O₁₂ as the target. The semiconductor particles in the paste are applied onto the transparent conductive layer 12, followed by sintering to form the photoelectrode layer 13. The composite is immersed in a solution containing the dye to form the dye-supported semiconductor particles and the counter electrode 15 is then formed, and the electrolytic solution is filled between the photoelectrode layer 13 and the counter electrode 15 forming the electrolyte 14. The dye-sensitized solar cell according to the second embodiment of the present invention can thus be manufactured.

In the dye-sensitized solar cell according to the second embodiment of the invention the transparent conductive film according to the first embodiment is arranged on the segment which contacts the electrolyte 14. This arrangement can prevent the corrosion by the electrolyte 14 and controls the deterioration of properties.

### 3. Third Embodiment

The solid electrolyte battery according to the third embodiment of the invention will be described. The solid electrolyte battery is the battery using the transparent conductive film according to the first embodiment. In the solid electrolyte battery, the transparent conductive film according to the first embodiment serves not only as an electrically conductive agent but also as an anode active material.

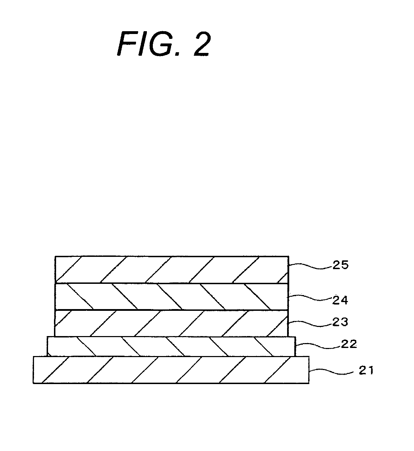

Fig. 2 illustrates the cross-sectional structure of the solid electrolyte battery according to the third embodiment of the invention. The solid electrolyte battery is a thin film solid electrolyte battery in which a cathode and an anode as the components of the battery and the material as the component of the electrolyte are arranged in a thin film multilayer structure. The solid electrolyte battery is, for example, a lithium ion secondary battery, in which upon charge lithium ions are released from the cathode and are absorbed through the solid electrolyte to the anode. Upon discharge lithium ions are released from the anode and are absorbed through the solid electrolyte to the cathode.

The solid electrolyte battery has the structure of which a cathode current collector layer 22, a cathode active material layer 23, a solid electrolyte layer 24, and an anode layer 25 are stacked on a substrate 21 in this order.

### (Substrate 21)

As the substrate 21, for example, substrates including electrical insulation materials such as glass, alumina, and resins, substrates including semiconductor materials such as silicon, substrates including electrical conductive materials such as aluminum, copper, and stainless steel can be used. The shape of the substrate 21 is particularly not limited, but includes, for example, the substrate-like shape, sheet-like shape, film-like shape, block-like shape, etc. The substrate 21 can be either hard or flexible and a wide variety of materials can be used.

### (Cathode Current Collector Layer 22)

The cathode current collector layer 22 is a thin film formed by the cathode current collector materials with good chemical stability and high electrical conductivity. The thin film herein denotes the material with thickness of, for example, a few µm or less and with a substantially small volume compared to the surface area. The cathode current collector materials include, for example, metal materials such as aluminum, nickel, stainless steel, copper, indium-tin oxides (ITO), platinum, gold, and silver.

### (Cathode Active Material Layer 23)

The cathode active material layer 23 is the thin film composed of the cathode materials, which can absorb and release lithium. As the cathode materials which can absorb and release lithium, for example, lithium transition metal composite oxides used in the ordinary lithium ion secondary battery can be used. Specifically, they include, for example, lithium manganese composite oxide with the spinel structure such as LiMn₂O₄, lithium composite oxides with a multilayered structure such as LiCoO₂, LiNiO₂, LiₓNi_{y}Co_{1-y}O₂ (values of x and y are varied depending on the state of charge and discharge of the battery and are generally 0<x<1.00 and 0<y<1.00), lithium phosphate compounds with the olivine structure such as LiFePO₄. A solid solution in which part of the transition metal elements is substituted with other elements can be used.

As other cathode active materials metal sulfides or metal oxides not containing lithium such as TiS₂, MoS₂, NbSe₂, and V₂O₅, or specific polymers such as polyaniline or polythiophene can be used. One or more types of any lithium composite oxides, metal sulfides, and metal oxides described above can be used alone or as a mixture.

### (Solid Electrolyte Layer 24)

The solid electrolyte layer 24 is composed of the lithium ion conductive material with negligible electronic conductivity. Such materials include, for example, Li₃PO₄, LiPON, NASICON type Li₁₊ₓMₓTi₂₋ₓ (PO₄) ₃ (M are different elements such as Al and Sc), perovskite type La_{2/3-x}Li₃ₓTiO₃, LISICON type Li₄₋ₓGe₁₋ₓPₓS₄, and β-Fe₂(SO₄) type Li₃M₂(PO₄)₃ (M are different elements such as In and Sc).

### (Anode Layer 25)

The anode layer 25 is composed of the transparent conductive film according to the first embodiment. That is, the anode layer 25 is composed of the transparent conductive film, which is formed by the sputtering deposition technique in the nitrogen-containing atmosphere using Li₄Ti₅O₁₂ as the target. The anode layer 25 can also be composed of the transparent conductive film according to the first embodiment and the film serving as an anode current collector. In this case as the materials for the composition of the film which serves as the anode current collector, for example, metal materials such as aluminum, nickel, stainless steel, copper, indium-tin oxides (ITO), platinum, gold, and silver can be used.

### (Method of Manufacturing Solid Electrolyte Battery)

The solid electrolyte battery above is manufactured, for example, by the following method.

The solid electrolyte battery can be obtained by forming on the substrate 21 the cathode current collector layer 22, the cathode active material layer 23, the solid electrolyte layer 24, and the anode layer 25 in this order. The cathode current collector layer 22, the cathode active material layer 23, and the solid electrolyte layer 24 can be formed by a known deposition method of the physical vapor deposition (PVD) method such as the sputtering method and the vapor phase method such as the chemical vapor deposition (CVD) method. The anode layer 25 can be formed by the sputtering deposition technique in the nitrogen-containing atmosphere using Li₄Ti₅O₁₂ as the target.

### [Examples]

The present invention is specifically described below according to the examples, but the examples are merely to illustrate, but in no way to limit the invention.

### <Example 1>

### (Preparation of Target Object)

As the powder raw materials Li₂CO₃ and TiO₂ were weighed in stoichiometric proportions and mixed using a ball mill to yield the mixed powder, which was fired in air at 800°C for 12 hours to yield Li₄Ti₅O₁₂ powder. Li₄Ti₅O₁₂ powder was pressed and molded to a tablet using a tablet press, followed by sintering in air at 800°C for 6 hours to yield a sintered compact of Li₄Ti₅O₁₂ as the target.

### (Preparation of Transparent Conductive Film)

The transparent conductive film was formed on the silicon wafer substrate using the sintered compact of Li₄Ti₅O₁₂ as the target and a radio frequency (RF) magnetron sputtering equipment under the sputtering conditions below.

### [Sputtering Conditions]

Sputtering pressure: 0.5 Pa
Power output: 50 W
Gas: Ar, 10 sccm and N₂, 10 sccm
Deposition temperature: ambient temperature (25°C)

### <Comparative Example 1>

The transparent film was formed on the silicon wafer substrate by using the sintered compact of Li₄Ti₅O₁₂ similar to Example 1 as the target and the RF magnetron sputtering equipment under the sputtering conditions below.

### [Sputtering Conditions]

Sputtering pressure: 0.5 Pa
Power output: 50 W
Gas: Ar, 10 sccm and O₂, 10 sccm
Deposition temperature: ambient temperature (25°C)

### (Confirmation of Transparency)

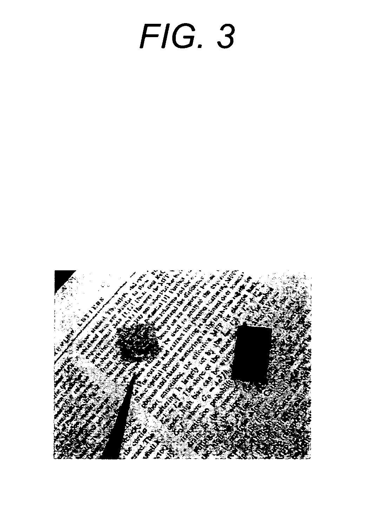

Fig. 3 illustrates a picture of the transparent conductive film of Example 1. As illustrated in the picture of Fig. 3, it was confirmed that the transparent conductive film of Example 1 is transparent, since the object such as characters can be seen through it.

### (Determination of Conductivity)

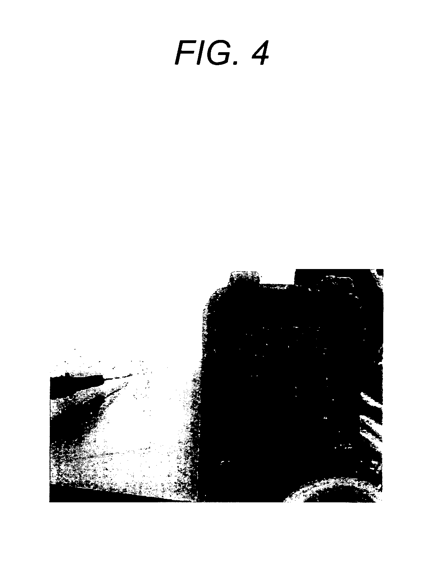

The surface resistivity was determined by the four probe method. The surface resistivity of the transparent conductive film of Example 1 was 2.56 MΩ/sq. As illustrated in a picture of Fig. 4, it was confirmed that the transparent film of Comparative Example 1 is not electrically conductive, as determining the presence or absence of the conduction in the transparent film of Comparative Example 1 using a digital tester.

### (XRD Analysis)

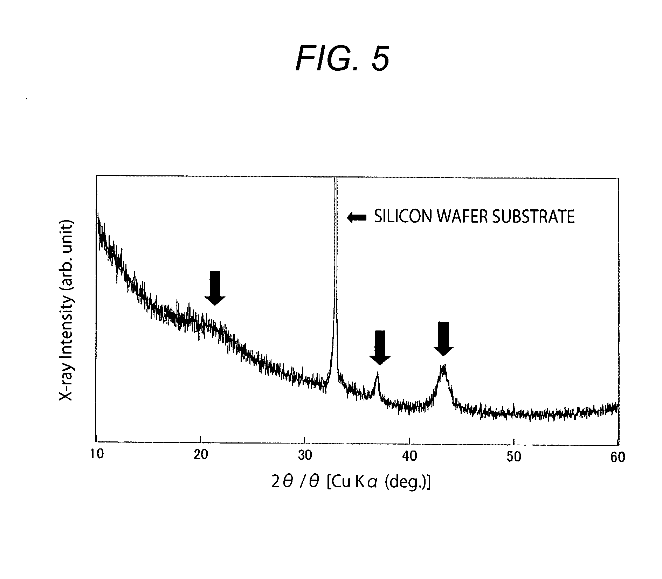

The XRD analysis was carried out for the transparent conductive film of Example 1. Fig. 5 illustrates the XRD pattern of the transparent conductive film in Example 1.

### (XPS Analysis)

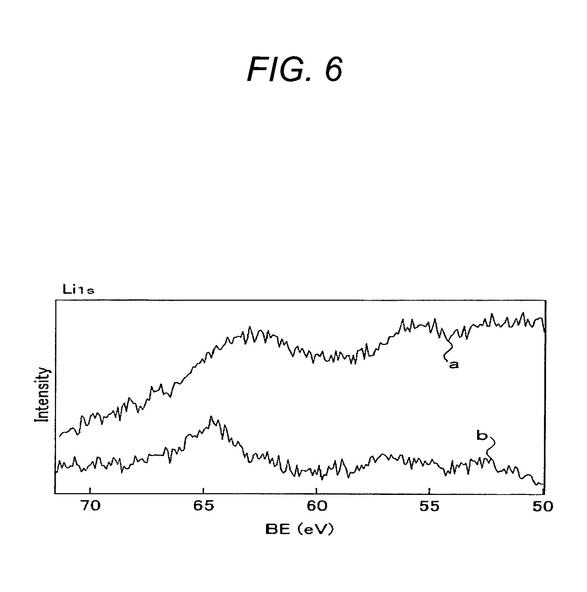

The X-ray photoelectron spectroscopy (XPS) analysis was carried out for the transparent conductive film of Example 1. The XPS analysis was also performed for the target before sputtering (sintered compact of Li₄Ti₅O₁₂) for the purpose of reference. Analytical results are demonstrated in Fig. 6. In Fig. 6, line (a) denotes the XPS spectrum of the transparent conductive film in Example 1, whereas line (b) denotes that of the target before sputtering (sintered compact of Li₄Ti₅O₁₂).

As illustrated in Fig. 5, the TiN peak indicated by the arrow was observed in the XRD pattern of the transparent conductive film of Example 1. As illustrated in Fig. 6, the Li 1s peak was observed in the XPS spectrum. That is, it was confirmed that the transparent conductive film of Example 1 contains Li.

### 4. Fourth Embodiment

The invention is not construed as limiting to the embodiments of the invention described above, but various modifications and applications can occur without departing from the scope of the invention. For example, the transparent conductive film of the invention can be applied to the transparent electrode used in displays such as the liquid crystal display, PVD display, and organic electroluminescence (EL) display, the transparent conductive film for solar cells other than the dye-sensitized fuel cell such as silicon type solar cells, electrically conductive glass, conductive films, etc.

### REFERENCE SIGNS LIST

- 11: Transparent substrate
- 12: Transparent conductive layer
- 13: Photoelectrode layer
- 14: Electrolyte
- 15: Counter electrode
- 21: Substrate
- 22: Cathode current collector layer
- 23: Cathode active material layer
- 24: Solid electrode layer
- 25: Anode layer

## Claims

1. A transparent conductive film formed by a physical vapor deposition method in a nitrogen-containing atmosphere using Li₄Ti₅O₁₂ as a target.

2. The transparent conductive film according to claim 1, wherein the physical vapor deposition method is a sputtering method.

3. The transparent conductive film according to claim 2, wherein the sputtering method is an RF magnetron sputtering method.

4. A method of manufacturing a transparent conductive film, comprising:
forming the transparent conductive film by a physical vapor deposition method in a nitrogen-containing atmosphere using Li₄Ti₅O₁₂ as a target.

5. A dye-sensitized solar cell comprising:
a transparent conductive layer;
a photoelectrode layer;
an electrolyte layer; and
a counter electrode,
wherein the transparent conductive layer contains a transparent conductive film formed by a physical vapor deposition method in a nitrogen-containing atmosphere using Li₄Ti₅O₁₂ as a target.

6. A solid electrolyte battery comprising:
a cathode layer;
an anode layer; and
a solid electrolyte layer,
wherein the anode layer contains a transparent conductive film formed by a physical vapor deposition method in a nitrogen-containing atmosphere using Li₄Ti₅O₁₂ as a target.
